# EUROPÄISCHE PATENTSCHRIFT

(11) **EP 0 525 355 B1**
(45) Veröffentlichungstag und Bekanntmachung des Hinweises auf die Patenterteilung: **13.09.1995**
(21) Anmeldenummer: 92110071.5
(22) Anmeldetag: 15.06.1992
(51) Int. Cl.: H04R 25/00

(54) **Hörgerät, insbesondere am Kopf tragbares Mini-Hörgerät, und Verfahren zur Herstellung**
Hearing aid, particularly on-the-head miniature hearing aid, and production method
Appareil de correction auditive notamment appareil miniature de correction auditive, portable sur la tête et procédé pour sa fabrication

(30) Priorität: 28.06.1991 DE 4121449
(43) Veröffentlichungstag der Anmeldung: 03.02.1993
(73) Patentinhaber: Siemens Audiologische Technik GmbH, 91058 Erlangen (DE)
(72) Erfinder: Strohmaier, Harald, W-8526 Bubenreuth (DE); Sauer, Joseph, Dipl.-Ing. (FH), W-8618 Strullendorf (DE)
(74) Vertreter: Fuchs, Franz-Josef, Dr.-Ing.

(56) Entgegenhaltungen:
- DE-A- 3 505 099
- DE-A- 3 840 190
- DE-U- 8 426 609

## Beschreibung

Die Erfindung betrifft ein Hörgerät, insbesondere ein am Kopf tragbares Mini-Hörgerät, mit einem Gehäuse, Schallwandlern, einer Verstärkereinheit, Stellelementen und einer Stromquelle, wobei die Verstärkereinheit aus einem Trägerbauteil und elektrischen Bauelementen besteht. Die Erfindung bezieht sich ferner auf Verfahren zur Herstellung des Hörgerätes.

Bei einem bekannten Hörgerät dieser Art (DE-U-8 426 609) sind zur Ausbildung der Verstärkereinheit elektronische bzw. elektrische Bauelemente, wie z.B. Kondensatoren, Widerstände, an einer Leiterplatte anzuordnen. Die elektrischen Bauteile weisen elektrische Anschlüsse zur Kontaktierung gegen Leiterbahnen der Leiterplatte auf. Die Kontaktstellen werden als Lötstellen ausgeführt. Nachteilig dabei ist, daß die zu kontaktierenden Bauteile (Bauelement und Trägerelement) lötfähig sein müssen. Probleme treten dabei ferner durch Hitzeeinwirkungen auf. Im Reparaturfall müssen die Lötstellen gelöst und wieder erneuert werden. Es ergibt sich eine aufwendige Montage und die Ausführung der Lötvorgänge beansprucht Platz, was zur Verorößerung der Leiterplatte führt.

Ferner sind (hinter dem Ohr zu tragende Hörhilfen (HdO-Geräte) auf dem Markt, deren Verstärkerbauteile als elektronische Komponenten ausgebildet sind, welche in Modulform Ummantelungen aus Epoxydharz aufweisen, auf einer Seite eine Kontaktleiste tragen und mit dieser Seite gegen eine Mutter-Leiterplatte über Steckverbindungen und Lötstellen kontaktiert sind. Dabei bilden die elektronischen Verstärkerbauteile vergossene Module, die in Paketform im Hörgerätegehäuse untergebracht sind. Diese Module sind zwar aufgrund ihres Mantels gegen Feuchtigkeit und äußere Einwirkungen geschützt, jedoch nicht zu reparieren und andererseits sehr platzaufwendig.

Bei der Oberflächenmontage mittels oberflächenmontierbarer Bauelemente (SMD-Technik) ist es bekannt, die elektrischen Bauelemente durch einen Klebevorgang auf der Leiterplatte mechanisch in der gewünschten Position zu fixieren. In einem weiteren Fertigungsvorgang werden dann diese Bauelemente gegen die Leiterplatte verlötet oder mittels Leitkleber elektrisch verbunden. Dieses Fertigungsverfahren hat beim Löten die bereits eingangs beschriebenen Nachteile und erfordert andererseits durch den Klebevorgang zum Fixieren der Bauteile einen zusätzlichen Arbeitsgang. Die Kontaktierung mittels Leitkleber erfordert eine genaue Dosierung des Leitklebers, setzt aufeinander abgestimmte zu verbindende Flächen voraus und erfordert einen Aushärtevorgang.

Aufgabe der Erfindung ist es, ein Hörgerät, insbesondere ein am Kopf tragbares Mini-Hörgerät, der eingangs genannten Art zu schaffen, dessen Verstärkereinheit sich durch eine miniaturisierte Ausbildung und eine vereinfachte Herstellung auszeichnet.

Diese Aufgabe wird erfindungsgemäß bei einem Hörgerät der eingangs genannten Art dadurch gelöst, daß ein zwischen den Bauelementen und dem Trägerbauteil vorgesehener, stark schrumpfbarer Kleber die Bauelemente mit Anpreßkraft gegen Kontaktstellen hält, derart, daß die Bauelemente mechanisch gegen die kontaktstellen des Trägerbauteiles gepreßt sind.

Ein Verfahren zur Herstellung des erfindungsgemäßen Hörgerätes ist im Patentanspruch 6 gekennzeichnet.

Auf vorteilhafte Weise kann der stark schrumpfbare Kleber auf das Trägerbauteil ohne besondere Struktur und ohne größere Anforderung an die Genauigkeit aufgebracht werden, z.B. durch Aufsprühen, Bestreichen oder durch Eintauchen des Trägerbauteils in ein Kleberbad. Daraufhin sind die elektrischen Bauelemente an die Kontaktstellen des Trägerbauteiles ansetzbar. Die Bestückung kann sehr vorteilhaft maschinell ausgeführt werden. Die Aushärtung/Schrumpfung des Klebers erfordert lediglich eine kurze Zeitdauer und benötigt keine zusätzliche Wärmebehandlung. Dadurch werden die bekannten, mit einer Wärmebehandlung verbundenen Nachteile vermieden. Andererseits läßt sich die Aushärtzelt auf einfache Weise durch eine UV-Bestrahlung verkürzen.

In weiterer Ausbildung kann auf das mit den Bauelementen bestückte und kontaktierte Trägerbauteil ein Überzug aus isolierendem Material aufgebracht werden. Die erfindungsgemäße Ausführung zeichnet sich besonders durch die einfache und rationelle Herstellung aus, wobei am Hörgerät noch Korrekturen bei der Montage sowie Reparaturen relativ leicht durchführbar sind. Die Verbindungen der Bauelemente mit dem Trägerbauteil sind frei von mechanischen Spannungen. Außerdem können beliebige Kontaktpartner verbunden werden, so daß sich eine bestimmte Materialauswahl und Materialpaarung erübrigt.

Da nach der Erfindung die elektrischen Bauelemente keiner Hitzebelastung durch ein Hand- oder z.B. Schwall- oder Reflowlöten ausgesetzt werden, werden bei der Bestückung weniger Bauelemente beschädigt und es sind preiswertere, weniger temperaturbeständige Bauelemente verwendbar.

Eine weitere erfindungsgemäße Lösung der Aufgabe bei einem Hörgerät der eingangs genannten Art zeichnet sich dadurch aus, daß über das mit den Bauelementen bestückte Trägerbauteil eine Folie, ein Folienschlauch oder ein Folienschlauchabschnitt angeordnet ist und die Bauelemente gegen Kontaktstellen drückt sowie in ihrer Lage fixiert, derart, daß die Bauelemente mechanisch gegen die Kontaktstellen des Trägerbauteils gepreßt sind. Ein zugehöriges Herstellungsverfahren gibt Patentanspruch 7 an.

Gemäß dieser Ausführung der Erfindung übernimmt die Folie, der Folienschlauch oder der Folienschlauchabschnitt gleichzeitig die Fixierung der Bauelemente gegenüber den Kontaktstellen, hält den zur Kontaktierung erforderlichen Anpreßdruck aufrecht und bildet eine Abschirmung gegen äußere Einflüsse. Dabei kann sich ein Überzugslack erübrigen, weil die Folie einen Schutzmantel gegen Korrosion und Feuchtigkeit bildet. Außerdem bildet die Folie einen Isolierungsschutz gegen elektrische Überschläge zwischen Chipbauteil-Kontakten.

Da nach den erfindungsgemäßen Ausführungen mittels schrumpfbarem Kleber bzw. mittels Folie kein Lötmittel erforderlich ist, können die Cu-Pads der Chips bzw. elektrischen Bauelemente sehr klein ausgeführt sein, was einer höheren Kompaktheit der Verstärkereinheit zugute kommt. Kleinvolumige Einbauteile sind insbesondere wegen des beschränkten Einbauraumes bei Mini-Hörgeräten, wie Im-Ohr-Hörgeräten, von Bedeutung, die im Gehörgang des Hörbehinderten getragen werden. Andererseits ist man auch bei hinter dem Ohr zu tragenden Hörhilfen (HdO-Geräten) bemüht, deren Gehäuse möglichst klein und unauffällig auszubilden.

Weitere vorteilhafte Ausgestaltungen der Erfindung sind in den Patentansprüchen 3 bis 5 und 8 bis 10 gekennzeichnet. Vorteile und Einzelheiten der Erfindung ergeben sich auch aus der nachfolgenden Beschreibung zu den in der Zeichnung dargestellten Ausführungsbeispielen.

In der Figur 1 ist in schematischer Darstellung ein aus Zwei Schalen 1′, 1˝ bestehendes Gehäuse 1 für ein HdO-Hörgerät im Schnitt dargestellt, wobei lediglich eine Verstärkereinheit 4 mit zwei Leiterplatten als Trägerbauteil 8 in das Gehäuse eingezeichnet ist, die unter Zwischenlage eines Dämmaterials 15 punkt- oder abschnittsweise gegen die Innenseiten der Gehäuseschalen abgestützt ist.

Figur 2 zeigt eine Draufsicht auf die Oberseite eines aus einer Leiterplatte bestehenden Trägerbauteils 8, das mit elektrischen Bauelementen 9, 9′, 9˝, 9‴ (z.B. Widerständen, Kondensatoren, Chipbausteinen od.dgl.) bestückt ist.

Figur 3 zeigt in vergrößertem Maßstab einen Schnitt durch ein gemäß der Erfindung am Trägerbauteil 8 angeordnetes elektrisches Bauelement 9.

Figuren 4 und 5 zeigen eine andere erfindungsgemäße Ausführung, bei der die an einem Trägerbauteil/Leiterplatte 8 angeordneten elektrischen Bauelemente 9 gegen die Kontaktstellen 10 der Leiterplatte durch eine Folie 12 fixiert und in Kontaktlage gehalten werden, wobei die Folie zugleich eine isolierende Schutzhülle bildet.

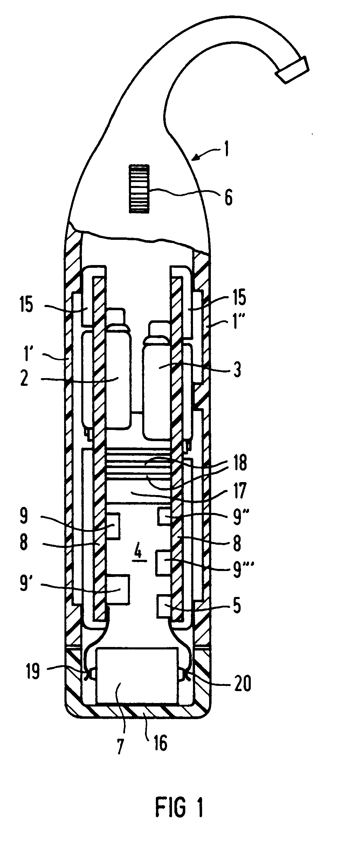

Das in Figur 1 dargestellte Hörgerät weist ein Gehäuse 1 auf, das aus zwei Gehäuseschalen 1′, 1˝ besteht. Im unteren Bereich des Gehäuses befindet sich bei dem als Ausführungsbeispiel schematisch gezeichneten HdO-Gerät ein Raum zur Aufnahme einer Stromquelle/Batterie 7, der über ein ausschwenkbares Gehäuseteil 16 (Batterielade) zugänglich ist. Mit 6 ist als Betätigungselement z.B. ein Lautstärkesteller angedeutet.

In dem Gehäuse 1 befindet sich ferner eine Verstärkereinheit 4, bestehend aus einem Trägerbauteil 8 aus beispielsweise zwei Leiterplatten/Verstärkerplatinen, die durch eine flexible Zone 17 miteinander verbunden sind. Die Leiterplatten sind mit elektrischen Bauelementen 9, 9′, 9˝, 9‴, wie Widerständen, Kondensatoren, Chips und gegebenenfalls mit Stellelementen 5, bestückt. Gemäß dem gezeichneten Ausführungsbeispiel sind ferner direkt auf dem Trägerbauteil 8 Eingangs- und Ausgangswandler 2 bzw. 3 angebracht. Dabei sitzt z.B. der Eingangswandler (Mikrofon) 2 an der einen Leiterplatte und der Ausgangswandler (Hörer) 3 an der zweiten Leiterplatte und beide Schallwandler sind mit ihren elektrischen Anschlüssen z.B. direkt gegen Leiterbahnen der Leiterplatte kontaktierbar. Die Leiterbahnen der Verstärkereinheit 4 sind durch über die flexible Zone 17 geführte flexible Leiterbahnabschnitte 18 zu einem Verstärkerschaltkreis verbunden. Zur Stromversorgung des Verstärkerstromkreises und der Schallwandler ist die Verstärkereinheit 4 über Federkontakte 19, 20 an die Stromquelle 7 anschließbar.

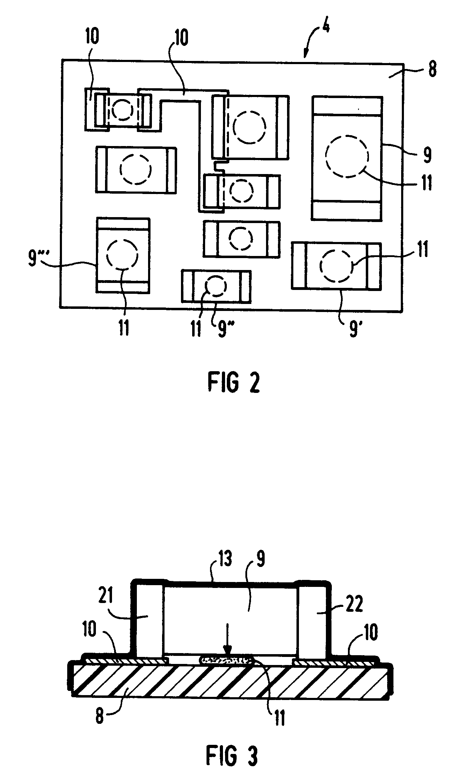

Gemäß Figur 2 ist das aus einer Leiterplatte bestehende Trägerbauteil 8 der Verstärkereinheit 4 mit elektrischen Bauelementen 9, 9′ , 9˝, 9‴ bestückt, deren Kupfer-Pads bzw. elektrischen Anschlüsse 21, 22 mit den Kontaktstellen 10 der Leiterplatte in elektrisch leitender Verbindung stehen. Erfindungsgemäß werden die Bauelemente in mechanischer Halterung gegen die Kontaktstellen gepreßt und zugleich in der Bestükkungs-/Kontaktlage gehalten. Dazu ist z.B. an den strichliert angedeuteten Stellen ein stark schrumpfbarer Kleber 11/Schnell- oder Sekundenkleber auf das Trägerbauteil aufgebracht , der nach dem Bestücken das elektrische Bauelement fixiert und aufgrund des Schrumpfvorganges in die Kontaktlage gegen die Kontaktstellen zieht und in dieser angezogenen Lage hält.

Aus Figur 3 ergibt sich die Kontaktlage zwischen den Cu-Pads 21, 22 des Chipbauteils 9 und den Kontaktstellen/Leiterbahnen 10 der Leiterplatte 8. Die Halte- und Zugkraft des schrumpfbaren Klebers 11 ist durch einen Pfeil angedeutet. Bei dieser Ausführung ist ferner das mit den Bauelementen 9 bestückte Trägerbauteil 8 mit einem Schutzüberzug 13 aus isolierendem Material, z.B. einem Polyurethanlack, überzogen.

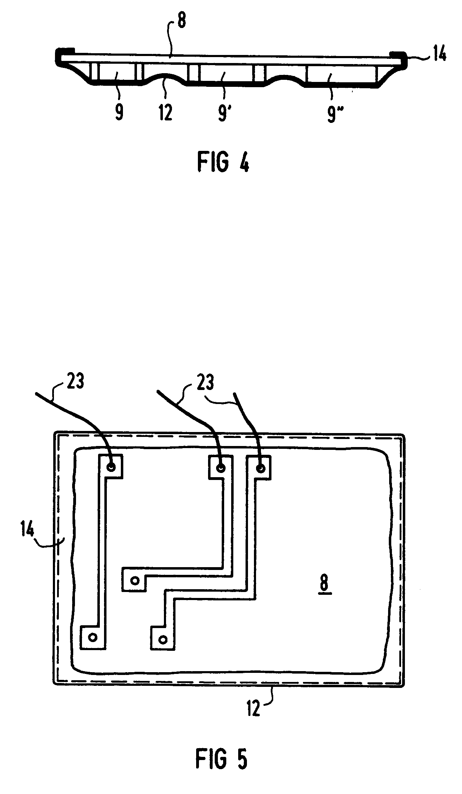

Gemäß der Ausführung der Figuren 4, 5 werden die elektrischen Bauelemente 9, 9′ , 9˝ mittels einer Folie 12 in Kontaktlage gegen die Kontaktstellen des Trägerbauteils 8 gehalten. Die Folie 12, ein Folienschlauch oder ein Folienschlauchabschnitt, bestehend aus Polyvinylchlorid, Silikon-Kautschuk, Polytetrafluoräthylen od.dgl., wird auf das mit den Bauelementen bestückte Trägerbauteil aufgebracht und dann durch Anlegen eines Unterdruckes gegen das Trägerbauteil gesaugt, so daß einerseits die Folie mit ausreichender Kontakt- und Haltekraft die Bauelemente gegen die zugeordneten Kontaktstellen drückt und andererseits sich in Spalte zwischen den Bauelementen einzieht. Die Folie bildet sonach gleichzeitig eine Schutzhülle und auch eine Isolierung zwischen den elektrischen Bauteilen.

In vorteilhafter Ausführung wird die Folie 12, der Folienschlauch, der Folienschlauchabschnitt, od.dgl. mit ihrem Randbereich 14 gegen das Trägerbauteil 8, insbesondere eine Leiterplatte, verschweißt, verklebt od.dgl. befestigt. Mit 23 sind Litzen für den Anschluß der Verstärkereinheit 4 an weitere elektrische Hörgerätebauteile bezeichnet.

Eine vorteilhafte Weiterbildung der Erfindung besteht darin, daß auf das mittels des Klebers 11 durch die Bauelemente 9 bestückte und kontaktierte Trägerbauteil 8 eine Folie 12 od.dgl. angeordnet und durch Anlegen eines Unterdruckes so gegen das Trägerbauteil gezogen wird, daß die Folie die Bauelemente an den vorgesehenen Stellen fixiert, unter Unterstützung des Kleberkontaktdruckes gegen die Kontaktstellen 10 hält und einen isolierenden Schutzmantel für das bestückte Trägerbauteil bildet. Nach dieser Ausbildung wird eine besonders geschützte Verstärkereinheit erhalten. Als stark schrumpffähiger Kleber kann insbesondere ein Silikonkleber verwendet werden.

In abgewandelter, nicht dargestellter Ausführung ist es möglich, daß ein Kunststoffteil mit elektrischen Verbindungen oder ein Hörgeräte-Gehäuseabschnitt (Abschnitt der Gehäuseinnenwand) mit integrierten oder auf der Oberfläche angebrachten Leitern bzw. Leiterbahnen das Trägerbauteil bildet.

## Patentansprüche

1. Hörgerät, insbesondere am Kopf tragbares Mini-Hörgerät, mit einem Gehäuse (1), Schallwandlern (2, 3), einer Verstärkereinheit (4), Stellelementen (5, 6) und einer Stromquelle (7), wobei die Verstärkereinheit (4) aus einem Trägerbauteil (8) und elektrischen Bauelementen (9-9‴) besteht, **dadurch gekennzeichnet**, daß ein zwischen den Bauelementen (9-9‴) und dem Trägerbauteil (8) vorgesehener, stark schrumpfbarer Kleber (11) die Bauelemente mit Anpreßkraft gegen Kontaktstellen (10) hält, derart, daß die Bauelemente mechanisch gegen die Kontaktstellen des Trägerbauteils gepreßt sind.

2. Hörgerät, insbesondere am Kopf tragbares Mini-Hörgerät, mit einem Gehäuse (1), Schallwandlern (2, 3), einer Verstärkereinheit (4), Stellelementen (5, 6) und einer Stromquelle (7), wobei die Verstärkereinheit (4) aus einem Trägerbauteil (8) und elektrischen Bauelementen (9-9‴) besteht, **dadurch gekennzeichnet**, daß über das mit den Bauelementen (9-9‴) bestückte Trägerbauteil (8) eine Folie (12), ein Folienschlauch oder ein Folienschlauchabschnitt angeordnet ist und die Bauelemente gegen Kontaktstellen (10) drückt sowie in ihrer Lage fixiert, derart, daß die Bauelemente mechanisch gegen die Kontaktstellen des Trägerbauteils gepreßt sind.

3. Hörgerät nach Anspruch 1, **dadurch gekennzeichnet**, daß als stark schrumpfender Kleber (11) ein Silikonkleber oder ein sogenannter Sekundenkleber vorgesehen ist.

4. Hörgerät nach den Ansprüchen 1 oder 2, **dadurch gekennzeichnet**, daß eine Leiterplatte, ein Kunststoffteil mit elektrischen Verbindungen oder ein Hörgeräte-Gehäuseabschnitt mit integrierten oder auf der Oberfläche angebrachten Leitern oder Leiterbahnen das Trägerbauteil (8) bildet.

5. Hörgerät nach Anspruch 2, **dadurch gekennzeichnet**, daß die Folie (12), der Folienschlauch oder der Folienschlauchabschnitt aus Polyvinylchlorid, Silikon-Kautschuk oder Polytetrafluoräthylen besteht.

6. Verfahren zur Herstellung eines Hörgerätes nach Anspruch 1, **dadurch gekennzeichnet**, daß der stark schrumpfbare Kleber (11) punkt-, linien- oder flächenförmig auf das Trägerbauteil (8) aufgebracht wird, die Bauelemente (9-9‴) gegen die zugeordneten Kontaktstellen (10) gedrückt werden und durch den schrumpfenden Kleber die Bauelemente zur Kontaktierung sowie Halterung gegen die Kontaktstellen gezogen werden.

7. Verfahren zur Herstellung eines Hörgerätes nach Anspruch 2, **dadurch gekennzeichnet**, daß über das mit den Bauelementen (9-9‴) bestückte Trägerbauteil (8) die Folie (12), der Folienschlauch oder der Folienschlauchabschnitt gelegt und durch Anlegen eines Unterdruckes so gegen das Trägerbauteil gezogen wird, daß die Folie, der Folienschlauch oder der Folienschlauchabschnitt die Bauelemente an den vorgesehenen Kontaktstellen (10) fixiert und mit dem gewünschten Kontaktdruck gegen die Kontaktstellen hält.

8. Verfahren nach Anspruch 6, **dadurch gekennzeichnet**, daß auf das mittels des Klebers (11) durch die Bauelemente (9-9‴) bestückte und kontaktierte Trägerbauteil (8) eine Folie (12), ein Folienschlauch oder ein Folienschlauchabschnitt angeordnet und durch Anlegen eines Unterdruckes so gegen das Trägerbauteil gezogen wird, daß die Folie, der Folienschlauch oder der Folienschlauchabschnitt die Bauelemente an den vorgesehenen Stellen fixiert, unter Unterstützung des Kleberkontaktzuges gegen die Kontaktstellen (10) hält und einen isolierenden Schutzmantel für das bestückte Trägerbauteil bildet.

9. Verfahren nach Anspruch 6, **dadurch gekennzeichnet**, daß das mit den Bauelementen (9-9‴) bestückte Trägerbauteil (8) mit einem Überzug (13) aus isolierendem Material, z.B. einem Polyurethanlack, versehen wird.

10. Verfahren nach Anspruch 7, **dadurch gekennzeichnet**, daß die Folie (12), der Folienschlauch oder der Folienschlauchabschnitt mit ihrem Randbereich (14) gegen das Trägerbauteil (8), insbesondere eine Leiterplatte, befestigt wird.

## Claims

1. Hearing aid, in particular a miniature hearing aid which can be worn on the head, having a housing (1), sound transducers (2, 3), an amplifier unit (4), control elements (5, 6) and a power source (7), whereby the amplifier unit (4) consists of a carrier part (8) and electrical components (9 - 9‴), characterized in that a highly shrinkable adhesive (11) provided between the components (9 - 9‴) and the carrier part (8) holds the components with contact pressure against contact points (10) in such a way that the components are mechanically pressed against the contact points of the carrier part.

2. Hearing aid, in particular a miniature hearing aid which can be worn on the head, having a housing (1), sound transducers (2, 3), an amplifier unit (4), control elements (5, 6) and a power source (7), whereby the amplifier unit (4) consists of a carrier part (8) and electrical components (9 - 9‴), characterized in that a film (12), a film tube or a film-tube section is arranged across the carrier part (8) fitted with the components (9 - 9‴) and presses the components against contact points (10) and fixes them in their position in such a way that the components are mechanically pressed against the contact points of the carrier part.

3. Hearing aid according to claim 1, characterized in that a silicone adhesive or a so-called seconds adhesive is provided as greatly shrinking adhesive (11).

4. Hearing aid according to claims 1 or 2, characterized in that a printed circuit board, a plastics part with electrical connections or a hearing-aid housing section with conductors or printed conductors which are integrated or fitted to the surface forms the carrier part (8).

5. Hearing aid according to claim 2, characterized in that the film (12), the film tube or the film-tube section consists of polyvinyl chloride, silicone rubber or polytetrafluoroethylene.

6. Method for the manufacture of a hearing aid according to claim 1, characterized in that the highly shrinkable adhesive (11) is applied to the carrier part (8) in dots, lines or area-wise, the components (9 - 9‴) are pressed against the associated contact points (10) and by way of the shrinking adhesive the components are pulled against the contact points for contacting and holding.

7. Method for the manufacture of a hearing aid according to claim 2, characterized in that the film (12), the film tube or the film-tube section is laid across the carrier part (8) fitted with the components (9 - 9‴) and through the application of a vacuum is pulled against the carrier part in such a way that the film, the film tube or the film-tube section fixes the components to the contact points (10) provided and holds them against the contact points with the desired contact pressure.

8. Method according to claim 6, characterized in that a film (12), a film tube or a film-tube section is arranged on the carrier part (8) fitted and contacted by way of the components (9 - 9‴) by means of the adhesive (11) and through the application of a vacuum is pulled against the carrier part in such a way that the film, the film tube or the film-tube section fixes the components to the points provided, with support of the adhesive contact pull holds them against the contact points (10) and forms an insulating protective cover for the fitted carrier part.

9. Method according to claim 6, characterized in that the carrier part (8) fitted with the components (9 - 9‴) is provided with a covering (13) of insulating material, for example a polyurethane lacquer.

10. Method according to claim 7, characterized in that the film (12), the film tube or the film-tube section is fastened with its edge region (14) against the carrier part (8), in particular a printed circuit board.

## Revendications

1. Appareil de correction auditive, notamment mini-appareil de correction auditive portable sur la tête, comportant un boîtier (1), des transducteurs acoustiques (2, 3), une unité d'amplificateur (4), des éléments de réglage (5, 6) et une source de courant (7), et dans lequel l'unité d'amplificateur (4) est constituée par un élément de support (8) et des composants électriques (9-9‴), caractérisé par le fait qu'un adhésif (11), qui est disposé entre les composants (9-9‴) et l'élément de support (8) et qui peut se rétracter fortement, maintient les composants sous l'action d'une force de serrage contre les zones de contact (10) de telle sorte que les composants sont repoussés mécaniquement contre les zones de contact de l'élément de support.

2. Appareil de correction auditive, notamment mini-appareil de correction auditive portable sur la tête, comportant un boîtier (1), des transducteurs acoustiques (2, 3), une unité d'amplificateur (4), des éléments de réglage (5, 6) et une source de courant (7), et dans lequel l'unité d'amplificateur (4) est constituée par un élément de support (8) et des composants électriques (9-9‴), caractérisé par le fait qu'une feuille (12), une feuille tubulaire ou un tronçon de feuille tubulaire est disposé par-dessus l'élément de support (8) équipé des composants (9-9‴) et repousse les composants contre des zones de contact (10) et les fixe dans leur position de telle sorte que les composants sont repoussés mécaniquement contre les zones de contact de l'élément de support.

3. Appareil de correction auditive suivant la revendication 1, caractérisé par le fait qu'on utilise, comme adhésif (11) qui subit une contraction importante, une colle silicone ou ce qu'on appelle une colle instantanée.

4. Appareil de correction auditive suivant les revendications 1 ou 2, caractérisé par le fait qu'une plaquette à circuits imprimés, une pièce en matière plastique comportant des liaisons électriques ou un élément de boîtier de l'appareil de correction auditive forme, avec des conducteurs ou des voies conductrices intégrées ou disposées sur la surface, l'élément de support (8).

5. Appareil de correction auditive suivant la revendication 2, caractérisé par le fait que la feuille (12), la feuille tubulaire ou le morceau de feuille tubulaire est constitué par du chlorure de polyvinyle, du caoutchouc silicone ou du polytétrafluoroéthylène.

6. Procédé de fabrication d'un appareil de correction auditive suivant la revendication 1, caractérisé par le fait qu'on dépose la colle (11) apte à se rétracter fortement, sous la forme de points, de lignes ou de surfaces sur l'élément de support (8), on repousse les composants (9-9‴) contre les zones de contact associées (10), les composants étant attirés par la colle rétractable pour l'établissement du contact avec les zones de contact et pour leur maintien contre ces zones.

7. Procédé de fabrication d'un appareil de correction auditive suivant la revendication 2, caractérisé par le fait qu'on dispose la feuille (12), la feuille tubulaire ou le tronçon de feuille tubulaire par-dessus l'élément de support (8) équipé des composants (9-9‴) et que moyennant l'application d'une dépression, on l'attire contre l'élément de support de telle sorte que la feuille, la feuille tubulaire ou le tronçon de feuille tubulaire fixe les composants contre les zones de contact prévues (10) et les maintient avec la pression de contact désirée contre les zones de contact.

8. Procédé suivant la revendication 6, caractérisé par le fait qu'on dispose une feuille (12), une feuille tubulaire ou un tronçon de feuille tubulaire sur l'élément de support (8), qui est équipé des composants (9-9‴) et est en contact avec eux, au moyen de la colle (11), et que par application d'une dépression, on l'attire contre l'élément de support de telle sorte que la feuille, la feuille tubulaire ou le tronçon de feuille tubulaire fixe les composants aux emplacements prévus, les maintient contre les zones de contact (10) d'une manière assistée par l'attraction du contact par adhérence et forme une enveloppe protectrice isolante pour un élément de support équipé.

9. Procédé suivant la revendication 6, caractérisé par le fait qu'on applique sur l'élément de support (8) équipé des composants (9-9‴) un revêtement (13) en un matériau isolant, par exemple un vernis à base de polyuréthane.

10. Procédé suivant la revendication 7, caractérisé par le fait qu'on fixe la feuille (12), la feuille tubulaire ou le tronçon de feuille tubulaire par sa zone marginale (14) contre l'élément de support (8), notamment une plaquette à circuits imprimés.
